# EUROPÄISCHE PATENTSCHRIFT

(11) **EP 0 541 647 B1**
(45) Veröffentlichungstag und Bekanntmachung des Hinweises auf die Patenterteilung: **11.10.1995**
(21) Anmeldenummer: 91914056.6
(22) Anmeldetag: 26.07.1991
(51) Int. Cl.: H01L 21/00, B05C 9/00, B05C 13/00

(54) **Schleuderteller für Substrate**
Substrate whirling plate
Plateau de centrifugation de substrats

(30) Priorität: 03.08.1990 DE 4024642
(43) Veröffentlichungstag der Anmeldung: 19.05.1993
(73) Patentinhaber: International Business Machines Corporation, Armonk, N.Y. 10504 (US)
(72) Erfinder: BÖHMER, Gudrun, D-7000 Stuttgart 80 (DE); GENTISCHER, Josef, D-7064 Remshalden (DE); LEHNER, Rolf, D-7300 Esslingen 1 (DE); MODJESCH, Dieter, D-7045 Nufringen (DE); SCHMUTZ, Wolfgang, D-7214 Zimmern 1 (DE)
(74) Vertreter: Schäfer, Wolfgang, Dipl.-Ing.
(86) Internationale Anmeldenummer: EP9101405
(87) Internationale Veröffentlichungsnummer: WO9202949

(56) Entgegenhaltungen:
- PATENT ABSTRACTS OF JAPAN vol. 13, no. 69 (C-569)(3417) 16. Februar 1989 & JP-A-63 258 667
- PATENT ABSTRACTS OF JAPAN vol. 6, no. 218 (E-139)(1096) 2. November 1982 & JP-A-57 121 227

## Beschreibung

Die Erfindung betrifft einen Schleuderteller für Substrate.

Substrate besitzen eine oder zwei einander gegenüberliegende aktive Oberflächen, die häufig nicht berührt und nicht kontaminiert werden dürfen. Zur Handhabung der Substrate weisen diese einen über die aktiven Oberflächen ragenden umlaufenden Rand auf. Bei der Behandlung der aktiven Oberflächen mit fließfähigen Substanzen, wie z.B. Lacken, Reinigungsmitteln oder dgl., werden die Substrate auf Schleuderteller gebracht, die mit hohen Drehzahlen rotieren, um die fließfähige Substanz gleichmäßig auf der aktiven Oberfläche zu verteilen und überschüssige Substanz abzuschleudern.

Vorrichtungen zum Schleudern der Substrate sind im wesentlichen in drei Ausführungen bekannt. In einer Ausführung ist das Substrat auf einem Drehkreuz mit acht in den Kreuzenden angebrachten Aufnahmestiften angeordnet. In einer zweiten Ausführung der eingangs genannten Gattung ist ein Schleuderteller mit einer kreisförmigen Tellerscheibe vorgesehen, auf deren Oberfläche Auflageklötze angeordnet sind. Die Auflageklötze weisen jeweils eine horizontale Auflagefläche, auf welcher das Substrat mit seinem Rand aufliegt, und eine vertikale Stützfläche auf, die das Substrat radial gegen die Zentrifugalkräfte abstützt. Eine solche Vorrichtung ist beispielsweise beschreiben in den Patent Abstracts of Japan, JP-A-57121227. In einer dritten Ausführung ist ein Schleuderteller mit einer kreisförmigen Tellerscheibe vorgesehen, die eine Ausfräsung zur Aufnahme des Substrates aufweist. Das Substrat wird mittels Stiften in diese Ausfräsung abgesenkt und aus ihr herausgehoben.

Bei allen diesen bekannten Schleudertellern liegt das Substrat lose auf dem Schleuderteller. Das Substrat wird nur durch die Schwerkraft auf dem Teller gehalten und radial gegen die Zentrifugalkraft abgestützt. Es kann daher vorkommen, daß sich das Substrat beim Schleudervorgang von dem Schleuderteller löst und infolge der hohen Zentrifugalkraft weggeschleudert wird. Dies führt zu einer Zerstörung des Substrates, was z.B. bei Keramiksubstraten sehr kostspielig sein kann, und zu einer Beschädigung der Anlage.

Eine spezielle Vorrichtung zum Fixieren des Substrats auf einem Schleuderteller ist bekannt aus den Patent Abstracts of Japan, JP-A-63258667. Bei dieser Vorrichtung wird das Substrat durch Unterdruck auf den Schleuderteller gepresst und somit während des Schleudervorgangs auf dem Schleuderteller festgehalten.

Der Erfindung liegt die Aufgabe zugrunde, einen Schleuderteller für Substrate zur Verfügung zu stellen, bei welchem das Substrat automatisch zentriert und beim Schleudern zuverlässig festgehalten wird.

Diese Aufgabe wird bei einem Schleuderteller der eingangs genannten Gattung erfindungsgemäß gelöst durch die Merkmale des Anspruches 1.

Vorteilhafte Ausführungsformen der Erfindung sind in den Unteransprüchen angegeben.

Bei den bekannten Schleudertellern wird das Substrat mit dem für das Einsetzen und Entnehmen notwendigen radialen Spiel aufgenommen. Eine exakte Zentrierung des Substrates fehlt daher. Erfindungsgemäß wird dagegen das Substrat durch ein Andrückglied gegen definierte Zentrieranschläge gedrückt, so daß eine exakte Zentrierung möglich ist. Die exakte Zentrierung des Substrates mit definierten Bezugskanten bei einem quadratischen, rechteckigen oder mehrkantigen Substrat oder mit definierten Bezugspunkten bei einem runden Substrat bezüglich der Zentrieranschläge und damit bezüglich der Drehachse des Schleudertellers ermöglicht z.B. eine lichtoptische Abtastung und Prüfung oder eine sonstige Behandlung des Substrates auf dem Schleuderteller.

Die Zentrierung des Substrates durch das Andrückglied wird vorteilhaft durch ein über die Antriebswelle zugeführtes Vakuum bewirkt, so daß zur Betätigung und Steuerung des Andrückgliedes keine aufwendigen mechanischen Krafteinleitungen in den rotierenden Schaltteller notwendig sind. Vorzugsweise wird das Andrückglied über eine vom Vakuum beaufschlagte Membran und eine Stelleinrichtung betätigt. Eine Drosseleinrichtung sorgt dafür, daß das über die Vakuumbohrung der Antriebswelle zugeführte Vakuum zunächst das Andrückglied zur Zentrierung des Substrates betätigt und erst dann mit einer gewissen zeitlichen Verzögerung das Substrat mit hoher Kraft an der Tellerscheibe ansaugt.

Bei dem erfindungsgemäßen Schleuderteller liegt das Substrat, z.B. ein Keramiksubstrat, während des Schleuderns nicht lose auf der Tellerscheibe und wird nur radial abgestützt, sondern das Substrat wird durch Vakuum an der Tellerscheibe angesaugt, so daß es sich nicht von den Auflageklötzen lösen und weggeschleudert werden kann. Zum Ansaugen des Substrates ist eine am überstehenden Rand des Substrates anliegende Dichtung vorgesehen. Das Evakuieren der durch diese Dichtung begrenzten Ansaugkammer zwischen dem Substrat und der Tellerscheibe erfolgt durch eine in der Antriebswelle verlaufende Vakuumbohrung. Das Anliegen der Dichtung am äußeren Rand des Substrates ergibt eine große Wirkfläche für den Unterdruck, so daß das Substrat mit einer großen Kraft an der Tellerscheibe gehalten wird. Die Dichtung schließt außerdem die der Tellerscheibe zugewandte untere aktive Oberfläche des Substrates hermetisch ab, so daß die zur Behandlung der oberen aktiven Oberfläche eingesetzten Substanzen nicht auf die untere Oberfläche einwirken können.

Im folgenden wird die Erfindung anhand eines in der Zeichnung dargestellten Ausführungsbeispieles näher erläutert.

Es zeigen :
- Figur 1: den Schleuderteller mit einem aufsitzenden Keramiksubstrat in einem diagonal zu dem Keramiksubstrat liegenden Axialschnitt,
- Figur 2: eine Draufsichtauf auf den Schleuderteller und
- Figur 3: den Schleuderteller in einem zur Seitenkante des Keramiksubstrates parallelen axialen Teilschnitt.

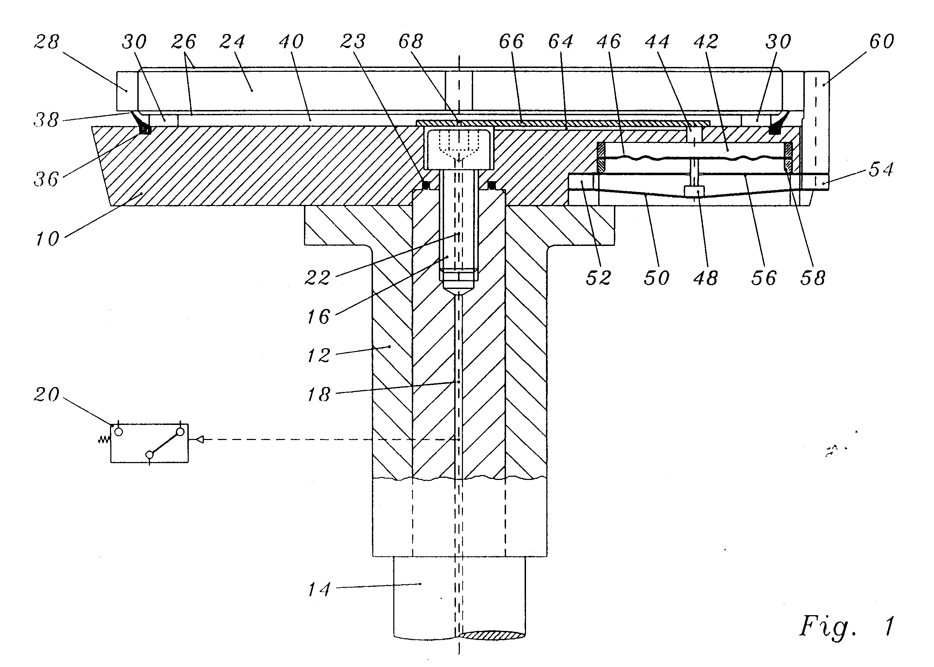

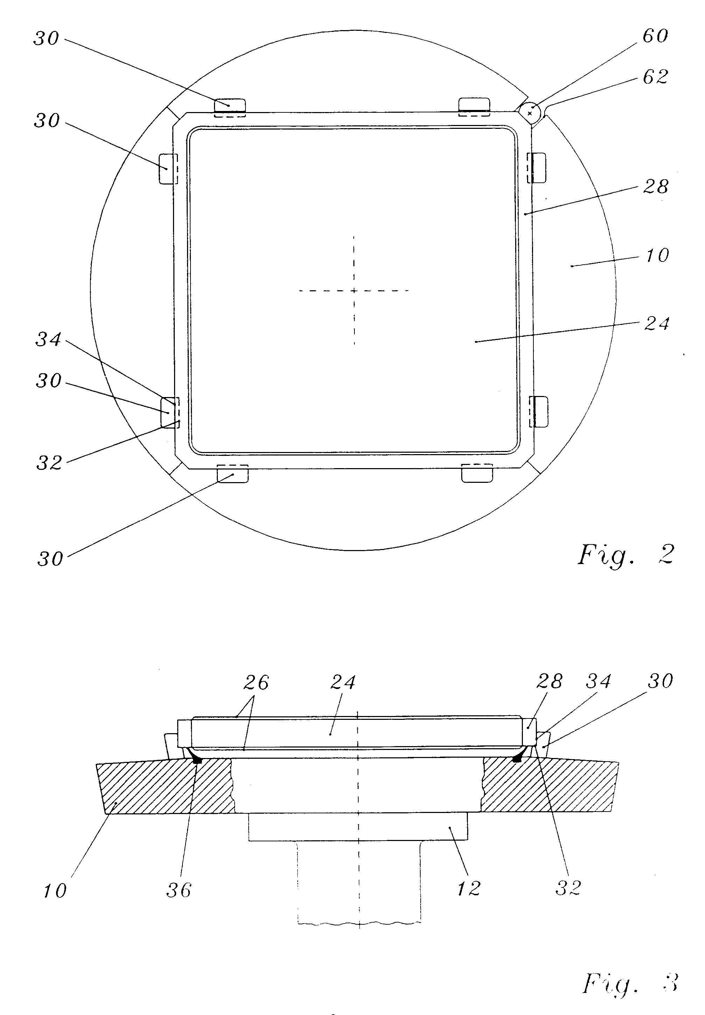

Wie die Figuren 1 und 2 zeigen, weist der Schleuderteller eine kreisförmige Tellerscheibe 10 auf, die mit einer Nabe 12 verschraubt ist. Die Nabe 12 sitzt für den Drehantrieb der Tellerscheibe formschlüssig auf einer Antriebswelle 14. Axial wird die Tellerscheibe 10 mittels einer zentrischen Schraube 16 auf der Antriebswelle 14 gehalten.

Die Antriebswelle 14 weist eine koaxiale Vakuumbohrung 18 auf, die zur Zuführung eines Vakuums an eine Saugpumpe angeschlossen wird. Der erreichte Unterdruck wird mittels eines herkömmlichen Vakuumschalters 20 festgestellt. Antriebswellen 14 mit einer Vakuumbohrung 18 und einem Vakuumschalter 20 sind bei herkömmlichen Anlagen teilweise vorhanden, um zu prüfen und zu kontrollieren, ob eine Tellerscheibe ordnungsgemäß auf der Antriebswelle sitzt.

Die Schraube 16 weist eine koaxiale durchgehende Bohrung 22 auf, die sich an die Vakuumbohrung 18 der Antriebswelle 14 anschließt, so daß die Vakuumbohrung 18 sich über diese Bohrung 22 bis zur Oberfläche der Tellerscheibe 10 fortsetzt. Ein zwischen die Antriebswelle 14 und die Tellerscheibe eingesetzter O-Ring 23 dichtet die Vakuum-Verbindung ab.

Auf der Oberseite der Tellerscheibe 10 wird ein Keramiksubstrat 24 aufgenommen. Das Keramiksubstrat 24 weist zwei aktive Oberflächen 26 auf. Über die aktiven Oberflächen 26 ragt ein umlaufender abgesetzter und beschliffener Rand 28 des Keramiksubstrates 24 hinaus. Dieser Rand 28 dient zur Handhabung der Substrates 24, da dessen aktive Oberflächen 26 nicht berührt werden dürfen.

Zur Aufnahme des Keramiksubstrates 24 auf der Oberseite der Tellerscheibe 10 sind auf dieser Auflageklötze 30 angebracht. Die Auflageklötze 30 weisen jeweils eine horizontale Auflagefläche 32 auf, auf welcher das Substrat 24 mit seinem Rand 28 aufliegt, und eine vertikale Stützfläche 34, die das Substrat 24 an der äußeren Stirnfläche des Randes 28 gegen radiale Verschiebung abstützt.

In dem dargestellten Ausführungsbeispiel ist ein quadratisches Keramiksubstrat 24 gezeigt. Dementsprechend sind acht Auflageklötze 30 vorgesehen, die jeweils paarweise das Substrat 24 an dessen vier Ecken halten. Soll ein Substrat anderer Form behandelt werden, z.B. ein mehreckiges oder rundes Substrat, so müssen die Auflageklötze 30 selbstverständlich in anderer Anordnung und gegebenenfalls anderer Anzahl angebracht werden.

In die obere Fläche der Tellerscheibe 10 ist eine entsprechend der Form des Keramiksubstrates 24 umlaufende Dichtung 36 eingesetzt. Die Dichtung 36 läuft innerhalb der Auflageklötze 30 um und liegt von unten an dem Rand 28 des Substrates 24 an. Hierzu weist die elastische Dichtung 36 einen glockenförmig nach außen geneigten verdünnten oberen Lippenrand 38 auf, der etwas über die Ebene der horizontalen Auflageflächen 32 der Auflageklötze 30 hinausragt, wenn kein Substrat 24 auf dem Schleuderteller sitzt. Wird das Substrat 24 auf den Schleuderteller aufgesetzt, so legt sich der Rand 28 des Substrates 24 zunächst auf den oberen Lippenrand 38 der Dichtung 36 auf. Der Lippenrand 38 gibt dabei elastisch nach, bis der Rand 28 des Substrates 24 auf den horizontalen Auflageflächen 32 der Auflageklötze 30 aufliegt. Die Dichtung 36 liegt dann unter leichtem elastischem Druck des Lippenbandes 38 dichtend an dem Rand 28 des Substrates 24 an.

Es wird dadurch zwischen dem Keramiksubstrat 24 und der Tellerscheibe 10 eine ringsum durch die Dichtung 36 abgeschlossene Ansaugkammer 40 gebildet. Diese Ansaugkammer 40 kann über die Vakuumbohrung 18 und die Bohrung 22 evakuiert werden, wobei durch den Unterdruck die glockenförmig nach außen geneigte Dichtung 36 nach innen gezogen wird und sich dadurch ihr Lippenrand 38 zusätzlich abdichtend gegen den Rand 28 des Substrates 24 anpreßt. Der in der Ansaugkammer 40 erzeugte Unterdruck wirkt auf die gesamte von der Dichtung 36 umschlossene große Fläche des Substrates 24, so daß dieses mit einer großen Kraft auf den Auflageklötzen 30 gehalten wird.

In die Unterseite der Tellerscheibe 10 ist nahe an deren Umfang exzentrisch eine Membrankammer 42 eingearbeitet. Die Membrankammer 42 steht über eine Bohrung 44 mit der Oberseite der Tellerscheibe 10 in Verbindung. Nach der Unterseite ist die Membrankammer 42 durch eine als Wellmembran ausgebildete Membran 46 abgeschlossen. An der der Membrankammer 42 entgegengesetzten Unterseite der Membran 46 trägt diese mittig einen Stößel 48. Das andere untere Ende des Stößels 48 ist etwa mittig an einer langgestreckten Blattfeder 50 befestigt. Die Blattfeder 50 ist radial an der Unterseite der Tellerscheibe 10 angeordnet und mit ihrem mittleren Bereich, an welchem der Stößel 48 befestigt ist, nach unten vorgewölbt. Das radial innere Ende der Blattfeder 50 ist mit einem Auflager 52 fest an der Tellerscheibe 10 befestigt. Das radial äußere Ende der Blattfeder 50 ist an einem Zwischenstück 54 befestigt. Zwischen der Membran 46 und der vorgewölbten Blattfeder 50 ist eine weitere Blattfeder 56 angeordnet, die parallel zu der vorgewölbten Blattfeder 50 in radialer Richtung verläuft. Die Blattfeder 56 ist jedoch eben. Das innere Ende der Blattfeder 56 ist ebenfalls mit dem Auflager 52 an der Tellerscheibe 10 festgelegt. Das radial äußere Ende der Blattfeder 56 ragt über eine nach unten weisende abgerundete Biegekante 58 der Tellerscheibe 10 hinaus und trägt auf der Unterseite dieses überstehenden Endes das Zwischenstück 54, an dessen Unterseite wiederum die vorgewölbte Blattfeder 50 befestigt ist. Der Stößel 48 durchsetzt frei beweglich eine Bohrung der ebenen Blattfeder 56. Auf der Oberseite des über die Biegekante 58 überragenden äußeren Endes der Blattfeder 56 ist dem Zwischenstück 54 gegenüber ein stiftförmiges Andrückglied 60 befestigt. Das Andrückglied 60 ragt durch eine Umfangsaussparung 62 der Tellerscheibe 10 nach oben über die Oberfläche der Tellerscheibe 10. Das obere Ende des Andrückgliedes 60 liegt an einer Ecke des Keramiksubstrates 24 von außen an dessen Rand 28 an. Das Andrückglied 60 ist durch Verbiegen der Blattfeder 56 über die Biegekante 58 nach innen schwenkbar gelagert. Die schwenkbare Lagerung durch die Blattfeder 56 und die Betätigung der Schwenkbewegung durch die Membran 46, den Stößel 48 und die vorgewölbte Blattfeder 50 kommen ohne Gelenke aus, in denen sich die flüssige Behandlungssubstanz festsetzen könnte. Der gesamte Mechanismus ist dadurch einfach und gründlich zu reinigen.

In der Oberfläche der Tellerscheibe 10 ist ein radial von der Bohrung 22 der Schraube 16 zu der Bohrung 44 der Membrankammer 42 führender Kanal 64 eingearbeitet, der gegen die Ansaugkammer 40 durch eine Deckelleiste 66 verschlossen ist. Eine Drosselbohrung 68 mit gegenüber dem Kanal 64 kleinerem Querschnitt führt durch die Deckelleiste 66 zu der Ansaugkammer 40.

Der Schleuderteller arbeitet in folgender Weise :

Das Keramiksubstrat 24 wird auf die Auflageklötze 30 der Tellerscheibe 10 aufgesetzt. Hierzu weisen die vertikalen Stützflächen 34 der Auflageklötze 30 ein geringes radiales Spiel gegenüber der Stirnfläche des Randes 28 des Keramiksubstrates 24 auf. Kommt das stiftförmige Andrückglied 60 beim Aufsetzen des Substrates 24 mit dessen Rand 28 in Berührung, so wird das Andrückglied 60 leicht radial nach außen gedrückt, wobei die Blattfedern 50 und 56 elastisch nachgeben. Eine Einlaufschräge an der Oberkante des Andrückgliedes 60 kann dieses Wegdrücken begünstigen.

Das Substrat 24 legt sich mit seinem Rand 28 auf den Lippenrand 38 der Dichtung 36 auf und drückt diesen nieder, bis der Rand 28 auf den horizontalen Auflageflächen 32 der Auflageklötze 30 aufsitzt. Dadurch ist die Ansaugkammer 40 abgedichtet.

Nun wird über die Vakuumbohrung 18 abgesaugt. Da der Kanal 64 einen größeren Durchtrittsquerschnitt als die Drosselbohrung 68 aufweist und da die Membrankammer 42 ein kleineres Volumen als die Ansaugkammer 40 aufweist, wird zunächst ein Vakuum in der Membrankammer 42 aufgebaut. Dieses Vakuum zieht die Membran 46 nach oben. Dadurch wird der Stößel 48 nach oben gezogen und zieht die nach unten vorgewölbte Blattfeder in ihre gestreckte Stellung. Die Streckung der Blattfeder 50 bewirkt eine radiale Schubkraft auf das äußere Ende der Blattfeder 50 nach außen, so daß die Unterseite des Zwischenstücks 54 nach außen gedrückt wird. Die ebene Blattfeder 56 biegt sich dabei um die Biegekante 58 nach oben und das Andrückglied 60 wird mit großer Hebelübersetzung radial nach innen gedrückt. Das Andrückglied 60 schiebt dabei das Substrat 24 gegen die als Zentrieranschläge dienenden vertikalen Stützflächen 34 der diametral gegenüberliegenden Auflageklötze.

Wenn dieser Zentriervorgang abgeschlossen ist, hat sich in der Ansaugkammer 40 ein Vakuum aufgebaut, das nun die Dichtung 36 mit ihrem Lippenrand 38 fest gegen den Rand 28 des Substrates 24 preßt und das Substrat 24 mit hoher Kraft auf den Auflageklötzen 30 festhält.

Der Vakuumschalter 20 signalisiert, wann der erforderliche Unterdruck für das Festhalten des Substrates 24 erreicht ist und der Schleudervorgang freigegeben werden kann.

Die umlaufende äußere Stirnfläche der Tellerscheibe 10 ist sich nach unten verjüngend abgeschrägt. Dadurch ergibt sich eine spitzwinklige obere Außenkante der Tellerscheibe 10, die als Abreißkante für das Abschleudern der flüssigen Behandlungssubstanzen dient. Dieser Effekt wird noch dadurch verbessert, daß im Bereich des über die Auflageklötze 30 hinausragenden Randes die Oberfläche der Tellerscheibe 10 leicht nach außen abfallend abgeschrägt ist, wie in Figur 3 zu erkennen ist. Dadurch fließen die flüssigen Behandlungssubstanzen auf der Tellerscheibe 10 nach außen und werden beim Schleudern definiert von der oberen Außenkante der Tellerscheibe als Abreißkante weggeschleudert.

## Patentansprüche

1. Schleuderteller für Substrate, die zwei aktive Oberflächen und einen diese überragenden umlaufenden Rand aufweisen, mit einer mittig von einer vertikalen Antriebswelle getragenen Tellerscheibe, mit auf der Oberfläche der Tellerscheibe angeordneten Auflageklötzen, die horizontale Auflageflächen und vertikale Stützflächen für den Rand des Substrates aufweisen, und mit einer axial in der Antriebswelle vorgesehenen Vakuumbohrung, wobei auf der Oberfläche der Tellerscheibe (10) eine umlaufende Dichtung (36) angeordnet ist, die an der Unterseite des Randes (28) des Substrates (24) anliegt, und die Vakuumbohrung (18) durch die Tellerscheibe (10) hindurch in eine zwischen der Tellerscheibe (10) und dem Substrat (24) gebildete von der Dichtung (36) umschlossene Ansaugkammer (40) geführt ist, wenigstens zwei auf einer Hälfte der Tellerscheibe (10) angeordnete Auflageklötze (30) mit ihren vertikalen Stützflächen (34) als Zentrieranschläge für das Substrat (24) dienen und diesen Auflageklötzen (30) gegenüber auf der anderen Hälfte der Tellerscheibe (10) ein Andrückglied (60) vorgesehen ist, das mit einer radial gerichteten Kraft gegen die Stirnfläche des Randes (28) des Substrates (24) bewegbar ist und dieses zur Anlage an die Zentrieranschläge drückt.

2. Schleuderteller nach Anspruch 1, dadurch gekennzeichnet, daß die Dichtung (36) mit einem glockenförmig nach außen geneigten verdünnten oberen Lippenrand (38) über die Ebene der horizontalen Auflageflächen (32) der Auflageklötze (30) ragt.

3. Schleuderteller nach Anspruch 1 oder 2, dadurch gekennzeichnet, daß das Andrückglied (60) mittels einer über die Vakuumbohrung (18) mit Vakuum beaufschlagbaren Membraneinrichtung gegen den Rand (28) des Substrates (24) bewegbar ist.

4. Schleuderteller nach Anspruch 3, dadurch gekennzeichnet, daß eine Drosseleinrichtung vorgesehen ist, die den Aufbau des Vakuums in der Ansaugkammer (40) gegenüber der Einwirkung auf die Membraneinrichtung verzögert.

5. Schleuderteller nach Anspruch 4, dadurch gekennzeichnet, daß die Vakuumbohrung (18) über einen Kanal (64) mit der Membraneinrichtung und über eine Drosselbohrung (68) kleineren Durchmessers mit der Ansaugkammer (40) in Verbindung steht.

6. Schleuderteller nach einem der Ansprüche 3 bis 5, dadurch gekennzeichnet, daß die Membraneinrichtung eine in der Tellerscheibe (10) ausgebildete, durch eine Membran (46) verschlossene, mit der Vakuumbohrung (18) kommunizierende Membrankammer (42) aufweist, daß an der der Membrankammer (42) entgegengesetzten Seite der Membran (46) eine das Andrückglied (60) verschwenkende Stelleinrichtung angebracht ist.

7. Schleuderteller nach Anspruch 6, dadurch gekennzeichnet, daß die Stelleinrichtung einen mit seinem einen Ende an der Membran (46) und mit seinem anderen Ende etwa mittig an einer Blattfeder (50) befestigten Stößel (48) aufweist, daß die Blattfeder (50) mit ihrem einen Ende festliegt und mit ihrem anderen Ende an dem schwenkbar gelagerten Andrückglied (60) befestigt ist und daß die Blattfeder (50) in ihrer Längserstreckung so gewölbt ist, daß bei Beaufschlagung der Membran (46) durch das Vakuum der Stößel (48) die Blattfeder (50) in ihre gestreckte Form bewegt.

8. Schleuderteller nach Anspruch 7, dadurch gekennzeichnet, daß das Andrückglied (60) zur schwenkbaren Lagerung am freien Ende einer über eine Biegekante (58) biegbaren Blattfeder (56) befestigt ist.

9. Schleuderteller nach wenigstens einem der vorhergehenden Ansprüche, dadurch gekennzeichnet, daß der über die Auflageklötze (30) hinausragende Rand der Tellerscheibe (10) an seiner Oberfläche nach außen abfällt und an seiner umlaufenden Stirnfläche sich nach unten verjüngend abgeschrägt ist.

## Claims

1. Whirling plate for substrates having two active surfaces and a circumferential margin projecting beyond these, with a plate disk mounted centrally on a vertical drive shaft, with supporting blocks mounted on the surface of the plate disk, having horizontal bearing surfaces and vertical supporting faces for the margin of the substrate, and with a vacuum bore provided axially in the drive shaft, with a continuous seal (36) mounted on the surface of the plate disk (10), said seal (36) being in contact with the underside of the margin (28) of the substrate (24), and with the vacuum bore (18) being led through the plate disk (10) into a vacuum chamber (40) enclosed by the seal (36) and formed between the plate disk (10) and the substrate (24), with at least two supporting blocks (30) fitted on one half of the plate disk (10) acting as vertical supporting surfaces (34) as centring stops for the substrate (24) and with a pressing element (60) being provided on the other half of the plate disk opposite said supporting blocks (30), said pressing element (60) being movable with a radially directed force against the face surface of the margin (28) of the substrate and pressing this into contact with the centring stops.

2. Whirling plate in accordance with claim 1, characterized in that the seal (36) projects above the plane of the horizontal bearing surfaces (32) of the supporting blocks (30) with a bell-shaped, outwardly inclined narrowing upper lip (38).

3. Whirling plate in accordance with claims 1 or 2, characterized in that the pressing element (60) can be moved against the margin (28) of the substrate (24) by means of a diaphragm device to which a vacuum can be applied through the vacuum bore (18).

4. Whirling plate in accordance with claim 3, characterized in that a choke device is provided which delays the build-up of the vacuum in the vacuum chamber (40) by comparison with the action of the diaphragm device.

5. Whirling plate in accordance with claim 4, characterized in that the vacuum bore (18) is connected with the diaphragm device through a duct (64) and with the vacuum chamber (40) through a choke bore (68) of smaller diameter.

6. Whirling plate in accordance with one of the claims 3 to 5, characterized in that the diaphragm device includes a diaphragm chamber (42) communicating with the vacuum bore (18) and formed in the plate disk (10) closed by a diaphragm (46), in that an actuator element pivoting the pressing element (60) is mounted on the side of the diaphragm (46) opposed to the diaphragm chamber (42).

7. Whirling plate in accordance with claim 6, characterized in that the actuating element incorporates a rod (48) one end of which is fastened to the diaphragm (46) and the other end of which is fastened approximately centrally on a leaf spring (50), in that the leaf spring (50) is fixed at one of its ends and the other end is fastened on the pressing element (60) which is mounted to allow it to pivot and in that the leaf spring (50) is curved in its longitudinal extent such that the rod (48) moves the leaf spring (50) into its extended form when the vacuum acts on the diaphragm (46).

8. Whirling plate in accordance with claim 7, characterized in that the pressing element (60) is fastened by its free end to a leaf spring (56) which can be bent over a bending edge (58) in order to provide a pivoting mounting.

9. Whirling plate in accordance with at least one of the preceding claims, characterized in that the margin of the plate disk (10) projecting beyond the support blocks (30) drops away outwards on its surface and its circumferential edge face is chamfered downwards.

## Revendications

1. Plateau de centrifugation pour substrats, présentant deux surfaces activeset une bordure circulaire les dépassant, avec une rondelle élastique bombée supportée au centre d'un arbre primaire vertical, avec des blocs d'appui agencés sur la surface de la rondelle élastique, qui présentent des surfaces d'appui horizontales et des surfaces de support verticales pour la bordure du substrat, et avec une forure sous vide prévue dans l'arbre primaire dans un sens axial, un joint circulaire (36) étant agencé sur la surface de la rondelle élastique (10), ce joint reposant sur la face inférieure de la bordure (28) du substrat (24) et la forure sous vide (18) traversant la rondelle élastique (10), dans une chambre d'aspiration (40) formée entre la rondelle élastique (10) et le substrat (24) et entourée par le joint (36); deux blocs d'appui (30) étant au minimum agencés sur une moitié de la rondelle élastique (10) servant de rebords de centrage au substrat (24), grâce à leurs surfaces de support verticales (34); un élément de serrage (60) étant prévu face à ces blocs d'appui (30), sur l'autre moitié de la rondelle élastique (10), cet élément pouvant se déplacer en direction de la face frontale de la bordure (28) du substrat (24), grâce à une force radiale, plaquant ainsi ce dernier contre les rebords de centrage.

2. Plateau de centrifugation selon la revendication 1, caractérisé en ce que le joint (36) dépasse du niveau des surfaces d'appui horizontales (32) des blocs d'appui (30), avec une bordure à lèvre (38) supérieure en forme de cloche amincie et inclinée vers l'extérieur.

3. Plateau de centrifugation selon la revendication 1 ou 2, caractérisé en ce que l'élément de serrage (60) peut se déplacer en direction de la bordure (28) du substrat (24) grâce à un dispositif à membrane pouvant se voir appliquer du vide par le biais d'une forure sous vide (18).

4. Plateau de centrifugation selon la revendication 3, caractérisé en ce qu'un dispositif d'étranglement a été prévu, qui permet de temporiser la formation du vide dans la chambre d'aspiration (40) par rapport à l'action sur le dispositif à membrane.

5. Plateau de centrifugation selon la revendication 4, caractérisé en ce que la forure sous vide (18) est reliée au dispositif à membrane au moyen d'un canal (64) et à la chambre d'aspiration (40) par une forure d'étranglement (68) de plus petit diamètre.

6. Plateau de centrifugation selon l'une des revendications 3 à 5, caractérisé en ce que le dispositif à membrane présente une chambre à membrane (42) formée dans la rondelle élastique (10), fermée par une membrane (46) et communiquant avec la forure sous vide (18) et en ce qu'un dispositif de réglage permettant de faire pivoter l'élément de serrage (60) est installé sur le côté de la membrane (46) opposé à la chambre à membrane (42).

7. Plateau de centrifugation selon la revendication 6, caractérisé en ce que le dispositif de réglage présente un coulisseau (48) dont une extrémité est fixée à la membrane (46) et l'autre extrémité de façon approximativement centrée sur un ressort à lames (50), en ce que l'une des extrémités du ressort à lames (50) est fixe, tandis que l'autre est fixée à l'élément de serrage (60) pivotant et en ce que le ressort à lames (50) est bombé sur son étendue longitudinale de telle sorte que le coulisseau (48) donne au ressort à lames (50) sa forme allongée lorsque la membrane (46) est soumise au vide.

8. Plateau de centrifugation selon la revendication 7, caractérisé en ce que l'élément de serrage (60) est fixé sur l'extrémité libre d'un ressort à lames (56) pouvant se plier par dessus un bord de flexion (58), afin d'assurer son pivotement.

9. Plateau de centrifugation selon au moins une des revendications précédentes, caractérisé en ce que le bord de la rondelle élastique (10) dépassant des blocs d'appui (30) s'affaisse vers l'extérieur et que sa surface frontale circulaire est biseautée vers le bas en diminuant.
